# EUROPEAN PATENT APPLICATION

(11) **EP 2 163 664 A1**
(43) Date of publication of application: **17.03.2010**
(21) Application number: 09010938.0
(22) Date of filing: 26.08.2009
(51) Int. Cl.: C23C 16/40

(54) **Method for depositing si-containing film, insulator film, and semiconductor device**

(30) Priority: 11.09.2008 JP 2008233035
(71) Applicant: Shin-Etsu Chemical Co., Ltd., Chiyoda-ku, Tokyo (JP)
(72) Inventor: Hamada, Yoshitaka, Kubiki-ku Joetsu-shi Niigata-ken (JP)
(74) Representative: TER MEER - STEINMEISTER & PARTNER GbR

(57) **Abstract**

A method for depositing a Si-containing film by plasma CVD is provided, and this method uses a silane compound as a film source. The silane compound has hydrogen atom or an alkoxy group as a reactive group, and has at least 2 silicon atoms in the molecule. The at least 2 silicon atoms are bonded by an intervening saturated hydrocarbon group. The ratio of the number of carbon atoms other than those included in the alkoxy group [C] to the number of silicon atoms [Si] ([C]/[Si]) is at least 3, and all silicon atoms are directly bonded to at least 2 carbon atoms. This method has realized an effective film deposition rate. Chemical stability of the film has also been improved by providing hydrophobicity with the film simultaneously with the suppression of the reactivity of the silicon atom for the nucleophilic reaction.

## Description

### TECHNICAL FIELD

This invention relates to a method for forming a Si-containing film by chemical vapor deposition (CVD), which is useful as an interlayer insulator film material with low dielectric constant for use in a multilayer interconnection in a logic ULSI. This invention also relates to an insulator film produced by this method and a semiconductor device.

### BACKGROUND OF THE INVENTION

Needs for a greater packing density and speedup are ever more increasing in the production technology of the IC field in electronics industry. In silicon ULSI, and in particular, in the logic ULSI, the current challenge resides not so much in the improvement of the performance by using a finer design rules in MOSFET but rather, in the improvement of the performance of the interconnect connecting the MOSFET. More specifically, decrease in the interconnect resistance and decrease in the inter-wiring and interlayer capacities are required in solving the problem of interconnect delay associated with the multilayer interconnection.

In view of such situation, replacement of aluminum interconnect which is currently used in most integrated circuits with copper interconnect has become inevitable since the copper interconnect has a lower electric resistance and a higher migration resistance. Under such situation, a process comprising the step of forming seeds by sputtering followed by copper plating has become a commercially practical.

Various proposals have been made for the interlayer insulator film material with low dielectric constant for use in reducing the inter-wiring and interlayer capacities, and examples of the conventional inorganic materials include silicon dioxide (SiO₂), silicon nitride, and phosphosilicate glass, and exemplary organic materials include polyimide. In order to form a more consistent interlayer insulator film, one recent proposal uses SiO₂ produced by hydrolysis, namely, polycondensasion of tetraethoxysilane monomer as a coating material for "spin on glass" (inorganic SOG). Also proposed is use of a polysiloxane obtained by polycondensation of an organic alkoxysilane monomer for the organic SOG.

Two categories of film formation methods are use in the formation of the insulator film. One is the coating method in which the solution of the polymer for the insulator film is coated by spin coating to form the insulator film, and the other is chemical vapor deposition (CVD), the typical method being plasma enhanced chemical vapor deposition (hereinafter also abbreviated as plasma CVD or PECVD) in which the source material is excited in plasma for reaction and film formation.

With regard to the plasma CVD, JP-A 2002-110670 proposes use of the plasma CVD for depositing a thin film of trimethylsilane oxide from trimethyl silane and oxygen, and JP-A 11-288931 proposes deposition by the plasma CVD of a thin film of an alkylsilane oxide from a straight chain alkyl such as methyl, ethyl, or n-propyl, an alkenyl such as vinylphenyl, or an alkoxy silane having an aryl group.

In order to further reduce the dielectric constant in the Si-containing film formed by plasma CVD, WO 2005/53009 proposes a method using a silane compound having a radically polymerizable organic group on its side chain wherein a Si-containing film is formed by polymerizing the polymerizable organic group under the CVD conditions, and US 2005/0194619A proposes a method using a silane in which the silicon atoms are connected by an intervening hydrocarbon group.

### SUMMARY OF THE INVENTION

However, a film which has been designed to have a higher porocity for the sake of the reduced dielectric constant suffers from the problem of process induced damage during the subsequent etching and washing steps.

For example, the materials like the one proposed in WO 2005/53009 have the problem that the unsaturated bond remaining in the film leads to unstable physical properties of the film due to the process induced damage in the subsequent steps although the method is capable of producing a film having a reduced dielectric constant with well-preserved organic side chain.

A material having a high porocity also suffers from increased risk of the damage by the treatment using an alkaline solution, and this damage starts from hydrophilization of the surface of the insulation film which invites increase in the dielectric constant of the film by the nucleophilic attack on the Si having the Si-O bond.

The present invention has been completed in view of the situation as described above, and an object of the present invention is to provide a novel method for depositing a Si-containing film by using a material which had never been used in producing the silicon oxide films in conventional CVD methods. Another object of the present invention is to provide an insulator film comprising the Si-containing film obtained by this method and a semiconductor device produced by using this insulator film.

The inventors of the present invention made an intensive study to realize the objects as described above, and found that a Si-containing film which has hydrophobicity and chemical stability higher than those of conventional films can be readily formed at an efficient film deposition rate when the silane compound used for the source of the plasma CVD has a ratio of the number of carbon atoms [C] other than those included in the reactive group (alkoxy group) bonded to the silicon atom to the number of silicon atoms [Si] ([C]/[Si]) of at least 3, the silane compound has at least 2 silicon atoms in the molecule, and all silicon atoms have at least 2 direct bonds with the carbon atom is used for the source in the plasma CVD. The present invention has been completed on the basis of such finding.

Accordingly, the present invention provides a method for depositing a Si-containing film by plasma CVD which uses a silane compound as a film source, wherein the silane compound has hydrogen atom or an alkoxy group as a reactive group, and has at least 2 silicon atoms in the molecule; the at least 2 silicon atoms are bonded by an intervening straight chain, branched, or cyclic saturated hydrocarbon group, the straight chain saturated hydrocarbon group optionally including a cyclic structure; ratio of the number of carbon atoms other than those included in the alkoxy group [C] to the number of silicon atoms [Si] ([C]/[Si]) is at least 3; and all silicon atoms are directly bonded to at least 2 carbon atoms.

When a silicon oxide film is formed by plasma CVD using such silane compound, a highly hydrophobic silicon oxide film which is stable in the subsequent steps of the process can be formed without compromising the film deposition rate.

The number of carbon atoms in one molecule of the silane compound is preferably up to 20.

By limiting the number of carbon atoms to up to 20 in selecting the silane compound, the CVD will be accomplished at an effective vapor pressure.

One preferred embodiment of the silane compound is the one represented by the following general formula (1): 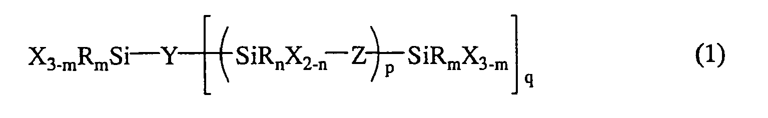 wherein
R is independently an alkyl group containing 1 to 6 carbon atoms,
X is independently hydrogen atom or an alkoxy group containing 1 to 4 carbon atoms,
Y is a straight chain, branched, or cyclic (q+1)-valent saturated hydrocarbon group containing 2 to 10 carbon atoms, the straight chain saturated hydrocarbon group optionally including a cyclic structure,
Z is a straight chain, branched, or cyclic divalent saturated hydrocarbon group containing 2 to 10 carbon atoms, the straight chain saturated hydrocarbon group optionally including a cyclic structure,
m is independently 1 or 2,
n is independently 1 or 2,
p is an integer of 0 to 2, and
q is an integer of 1 to 3,
with the proviso that the number of carbon atoms in the entire molecule doe not exceed 20, and ratio of the entire number of carbon atoms in the R, Y, and Z to the entire number of silicon atoms is at least 3.

An embodiment of such silane compound is the one represented by the following general formula (2):

X₃₋ₘRₘSi-(CH₂)ₖ-SiRₘX₃₋ₘ (2)

wherein R, X, and m are as defined above for the general formula (1); k is an integer of 2 to 6; and ratio of the number of carbon atoms in the methylene chain between the R and silicon to the entire number of silicon atoms is at least 3, and the entire number of carbon atoms is up to 20.

The present invention also provides an insulator film produced by the method for depositing a Si-containing film as described above.

The insulator film produced by the film deposition method of the present invention has high chemical stability, and in particular, high resistance to alkaline washing solution.

The present invention also provides a semiconductor device having such insulator film.

The semiconductor device having such insulator film is a highly reliable since the insulator film is less likely to experience change in its physical properties during the production process.

### ADVANTAGEOUS EFFECT OF INVENTION

As described above, the present invention has realized an effective film deposition rate with no major change in the conventional CVD process. Chemical stability of the film has also been improved by providing hydrophobicity with the film simultaneously with reducing the reactivity of the silicon atom for the nucleophilic reaction.

In addition a semiconductor integrated circuit experiencing with reduced interconnect signal delay can be stably produced by using the film deposition method of the present invention in the production of the multilayer interconnected insulator film.

### BRIEF DESCRIPTION OF THE DRAWING

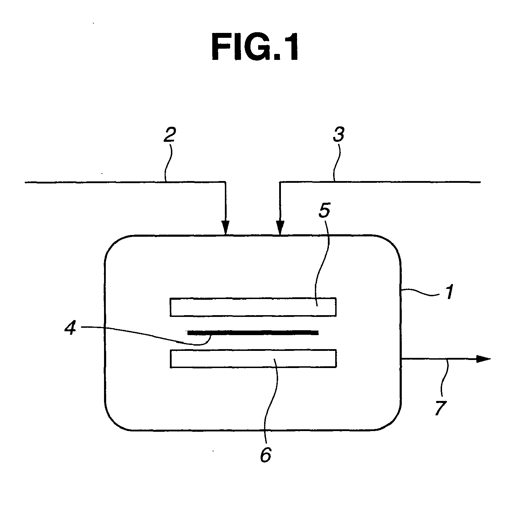

FIG. 1 is a schematic view of a parallel plate, capacitively coupled plasma enhanced chemical vapor deposition (PECVD) reactor.

### DETAILED DESCRIPTION OF THE INVENTION

Next, the present invention is described in detail.

The silane compound used in the film formation in the method for depositing a Si-containing film by plasma CVD of the present invention is a silane compound wherein the silane compound has hydrogen atom or an alkoxy group as a reactive group, and has at least 2 silicon atoms in the molecule; the at least 2 silicon atoms are bonded by an intervening straight chain, branched, or cyclic saturated hydrocarbon group, the straight chain saturated hydrocarbon group optionally including a cyclic structure; ratio of the number of carbon atoms other than those included in the alkoxy group [C] to the number of silicon atoms [Si] ([C]/[Si]) is at least 3; and all silicon atoms are directly bonded to at least 2 carbon atoms.

As described above, various method for depositing the Si-containing film by CVD have been proposed by using various materials. However, in most methods, the film is designed so that the silicon atoms are bonded by intervening oxygen. This is presumably because of the relatively large bonding energy between the silicon and oxygen which benefits for the stable and efficient film deposition rate in the CVD step.

In contrast, US 2005/0194619A proposes use of a compound containing two or more silicon atoms which are bonded by an intervening hydrocarbon group to thereby obtain a film having reduced dielectric constant. It was the idea of the inventors of the present invention that such skeleton including two or more silicon atoms bonded by an intervening hydrocarbon could be used in realizing the chemical stability. More specifically, most silicon atoms in the film should have 3 or 4 bonds to constitute the three dimensional structure, and as described above, these bonds are usually bonds by intervening oxygen atom. The oxygen atom bonded to the silicon atom, however, increases reactivity of the silicon atom for the nucleophilic reaction by its polalization effect. This in turn means that the reactivity of the silicon atom for the nucleophilic substance would be suppressed if the bond by the oxygen atom could be replaced with the bond by the hydrocarbon group. In other words, when the silane compound used for the source material is the one having at least 2 silicon atoms in the molecule and the at least 2 silicon atoms are crosslinked by a straight chain, branched, or cyclic saturated hydrocarbon group, the straight chain saturated hydrocarbon group optionally containing a cyclic structure, the three dimensional structure could be constituted even if the number of bonds of the silicon atom with the oxygen atom is 2. In addition, the reduced number of oxygen atoms bonded to the silicon atom would result in the reduced degree of the polarization of the silicon atom, and this would result in the suppressed reactivity for the nucleophilic reaction.

In the meanwhile, film design for the hydrophobicity of the film as a bulk is also important in realizing the chemical stability. Increase in the hydrophobicity of the film as a bulk results not only in the reduced reactivity of the film at the interface with an alkaline aqueous solution but also in the prevention of the change in the film quality by penetration of the alkaline aqueous solution into the pores through the pores. For providing such hydrophobicity with the film, selection of a saturated hydrocarbon group for the substituent of the side chains and intervening bonding moiety of the silicon atoms is advantageous. Selection of the saturated hydrocarbon group also enables estimation of the physical properties of the film related to the approximate hydrophobicity of the film as a bulk by means of the carbon to silicon ratio.

The hydrophobicity that is required for the resistance to the treatment using an aqueous solution which is an object of the present invention may be realized by limiting the silane compound used for the source material to the one in which the ratio of the number of carbon atoms other than those in alkoxy group [C] to the number of silicon atoms [Si] ([C]/[Si]) is at least 3 for the sake of convenience. The film will be more reliably provided with the hydrophobicity if the [C]/[Si] ratio is at least 4.

It should also be noted that the material used in the plasma CVD needs to have a certain level of vapor pressure, and the silane compound as described above containing up to 20 carbon atoms are generally applicable.

In addition, the saturated hydrocarbon substituent bonded to the silicon atom should be highly preserved during the plasma CVD and the carbon atom directly bonded to the silicon atom is preferably free from branched structure which is more likely to generate radicals.

The silane compound used in the film formation by the plasma CVD method of the present invention may be the one represented by the following general formula (1): 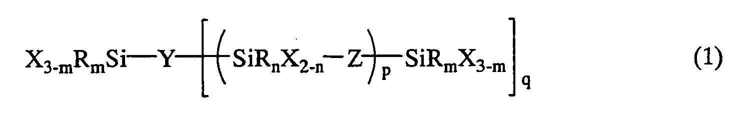 wherein
R is independently an alkyl group containing 1 to 6 carbon atoms,
X is independently hydrogen atom or an alkoxy group containing 1 to 4 carbon atoms,
Y is a straight chain, branched, or cyclic (q+1)-valent saturated hydrocarbon group containing 2 to 10 carbon atoms, the straight chain saturated hydrocarbon group optionally including a cyclic structure,
Z is a straight chain, branched, or cyclic divalent saturated hydrocarbon group containing 2 to 10 carbon atoms, the straight chain saturated hydrocarbon group optionally including a cyclic structure,
m is independently 1 or 2,
n is independently 1 or 2,
p is an integer of 0 to 2, and
q is an integer of 1 to 3,
with the proviso that the number of carbon atoms in the entire molecule doe not exceed 20, and ratio of the entire number of carbon atoms in the R, Y, and Z to the entire number of silicon atoms is at least 3.

When m and n are at least 1 in the general formula (1), number of oxygen atoms bonding to the silicon atom in the formula (1) will be limited to up to 2, and nucleophilic reactivity is thereby suppressed. In addition, the reactive group X which is an alkoxy group or hydrogen is the moiety where crosslinking takes place in the film formed by the plasma CVD. At the level of the entire molecule, the ratio of the number of carbon atoms included in R, Y, and Z to the number of silicon atoms is designed to be at least 3.

As described above, the carbon atoms directly bonded to the silicon atom in the R, Y, and Z are preferably not branched, and when the R, Y, and Z are substituents containing 2 or more carbon atoms, the carbon atoms directly bonded to the silicon atom is preferably bonded to the silicon atom in form of the structure -CH₂-.

Preferred examples of the R include methyl, ethyl, propyl, butyl, pentyl, and hexyl, and while the butyl, pentyl, and hexyl can be a branched isomer in addition to the straight chain group, the moiety directly bonded to the silicon preferably has methylene (-CH₂-) structure. When all of the R are ethyl or an alkyl substituent containing 3 or more carbon atoms, ratio of the number of carbon atoms other than those included in the reactive substituents [C] to the number of silicon atoms [Si] ([C]/[Si]) will be at least 3 irrespective of the structure of the Y and Z, and similarly, the ratio [C]/[Si] will be at least 4 when all of the R are propyl or a higher alkyl substituent.

Preferable examples of the Y and Z include dimethylene, trimethylene, tetramethylene, pentamethylene, hexamethylene, heptamethylene, and octamethylene, and the dimethylene and trimethylene may be substituted with an alkyl substituent as long as the number of carbon atoms in the entire molecule is up to 10. The moiety directly bonded to the silicon may preferably have methylene (-CH₂-) structure. Also preferred are substituents such as diethylene cyclohexane and diethylene cyclopentane having a cyclic saturated hydrocarbon skeleton in the intermediate.

The silane compound represented by the general formula (1) is more preferably the one having the structure represented by the following general formula (2):

X₃₋ₘRₘSi-(CH₂)ₖ-SiRₘX₃₋ₘ (2)

wherein R, X, and m are as defined above for the general formula (1); k is an integer of 2 to 6; and ratio of the number of carbon atoms in the methylene chain between the R and silicon to the entire number of silicon atoms is at least 3, and the entire number of carbon atoms is up to 20.

Preferable examples of the silane compound represented by the general formula (2) include
1,2-bis(ethyldimethoxysilyl)ethane,
1,2-bis(propyldimethoxysilyl)ethane,
1,2-bis(butyldimethoxysilyl)ethane,
1,2-bis(pentyldimethoxysilyl)ethane,
1,2-bis(hexyldimethoxysilyl)ethane,
1,2-bis(dimethylmethoxysilyl)ethane,
1,2-bis(diethylmethoxysilyl)ethane,
1,2-bis(dipropylmethoxysilyl)ethane,
1,2-bis(dibutylmethoxysilyl)ethane,
1,2-bis(ethyldiethoxysilyl)ethane,
1,2-bis(propyldiethoxysilyl)ethane,
1,2-bis(butyldiethoxysilyl)ethane,
1,3-bis(ethyldimethoxysilyl)propane,
1,3-bis(propyldimethoxysilyl)propane,
1,3-bis(butyldimethoxysilyl)propane,
1,3-bis(pentyldimethoxysilyl)propane,
1,3-bis(hexyldimethoxysilyl)propane,
1,3-bis(dimethylmethoxysilyl)propane,
1,3-bis(diethylmethoxysilyl)propane,
1,3-bis(dipropylmethoxysilyl)propane,
1,3-bis(ethyldiethoxysilyl)propane,
1,3-bis(propyldiethoxysilyl)propane,
1,3-bis(butyldiethoxysilyl)propane,
1,4-bis(methyldimethoxysilyl)butane,
1,4-bis(ethyldimethoxysilyl)butane,
1,4-bis(propyldimethoxysilyl)butane,
1,4-bis(butyldimethoxysilyl)butane,
1,4-bis(pentyldimethoxysilyl)butane,
1,4-bis(hexyldimethoxysilyl)butane,
1,4-bis(dimethylmethoxysilyl)butane,
1,4-bis(diethylmethoxysilyl)butane,
1,4-bis(dipropylmethoxysilyl)butane,
1,4-bis(methyldiethoxysilyl)butane,
1,4-bis(ethyldiethoxysilyl)butane,
1,4-bis(propyldiethoxysilyl)butane,
1,4-bis(butyldiethoxysilyl)butane,
1,5-bis(methyldimethoxysilyl)pentane,
1,5-bis(ethyldimethoxysilyl)pentane,
1,5-bis(propyldimethoxysilyl)butane,
1,5-bis(butyldimethoxysilyl)pentane,
1,5-bis(pentyldimethoxysilyl)pentane,
1,5-bis(dimethylmethoxysilyl)pentane,
1,5-bis(diethylmethoxysilyl)pentane,
1,5-bis(dipropylmethoxysilyl)pentane,
1,5-bis(methyldiethoxysilyl)pentane,
1,5-bis(ethyldiethoxysilyl)pentane,
1,5-bis(propyldiethoxysilyl)pentane,
1,6-bis(methyldimethoxysilyl)hexane,
1,6-bis(ethyldimethoxysilyl)hexane,
1,6-bis(propyldimethoxysilyl)hexane,
1,6-bis(butyldimethoxysilyl)hexane,
1,6-bis(pentyldimethoxysilyl)hexane,
1,6-bis(hexyldimethoxysilyl)hexane,
1,6-bis(dimethylmethoxysilyl)hexane,
1,6-bis(diethylmethoxysilyl)hexane,
1,6-bis(dipropylmethoxysilyl)hexane,
1,6-bis(methyldiethoxysilyl)hexane,
1,6-bis(ethyldiethoxysilyl)hexane,
1,6-bis(propyldiethoxysilyl)hexane,
1,7-bis(methyldimethoxysilyl)heptane,
1,7-bis(ethyldimethoxysilyl)heptane,
1,7-bis(propyldimethoxysilyl)heptane,
1,7-bis(butyldimethoxysilyl)heptane,
1,7-bis(pentyldimethoxysilyl)heptane,
1,7-bis(dimethylmethoxysilyl)heptane,
1,7-bis(diethylmethoxysilyl)heptane,
1,7-bis(methyldiethoxysilyl)heptane,
1,7-bis(ethyldiethoxysilyl)heptane,
1,8-bis(methyldimethoxysilyl)octane,
1,8-bis(ethyldimethoxysilyl)octane,
1,8-bis(propyldimethoxysilyl)octane,
1,8-bis(butyldimethoxysilyl)octane,
1,8-bis(pentyldimethoxysilyl)octane,
1,8-bis(dimethylmethoxysilyl)octane,
1,8-bis(diethylmethoxysilyl)octane,
1,8-bis(methyldiethoxysilyl)octane, and
1,8-bis(ethyldiethoxysilyl)octane.

In the present invention, the silane compound as described above is used as a source gas which is introduced in the CVD reactor in the form of a gas, and the Si-containing film is deposited by CVD, and in particular, by plasma enhanced chemical vapor deposition (PECVD). In the CVD, selection of a slightly lower energy range is preferable for the better preservation of the organic group and selective activation of the reactive group, namely, the alkoxy group or the hydrogen atom. When a parallel plate plasma CVD reactor using a 300 mm wafer is used, the radio frequency power (RF power) applied between the electrodes for plasma enhancement is preferably up to 300 W, more preferably up to 200 W, and most preferably up to 100 W since the reaction at lower energy allows higher reflection of the degree of bonding strength in the source gas, namely higher reflection of the reactive group selected. The lower limit is generally at least 20 W, and in particular, at least 50 W.

Other conditions may be selected from those known for the CVD which are well known in the art. For example, the vaporization of the silane compound may be accomplished by the method selected from those using a reduced pressure, bubbling delivery using a carrier gas, a vaporizer, and the like known in the art, which may be used alone or in combination of two or more. In view of controlling the amount of silane compound fed to the CVD process, it would be preferable to adopt a method in which the silane compound is supplied to a vaporizer at a constant flow rate, for example, by liquid mass flow or the like, and vaporized in the vaporizer.

The pressure and the temperature in the reactor and the temperature of the substrate on which the film is deposited may be adequately selected depending on the type and composition of the source gas. The CVD, however, is generally performed, preferably at a reduced pressure, and in particular, at a pressure in the range of 0.01 to 1,000 Pa, and the temperature of the substrate on which the film is deposited is preferably controlled to a temperature of -50°C to 500°C. The film deposition time is preferably in the range of 20 to 2,000 seconds although the time should be adequately selected depending on the reaction conditions as described above and the desired film thickness, and formation of a Si-containing film (insulator film) having a thickness of 50 to 2,000 nm, and in particular, 100 to 300 nm is preferable.

The plasma source used may be any of known sources such as RF plasma, microwave plasma, electron cyclotron resonance plasma, inductively coupled plasma, and helicon wave plasma.

In depositing the Si-containing film, a gas produced by vaporizing the silane compound as described above is introduced in the CVD reactor. However, a gas other than such gas may also be introduced in the reactor, and exemplary such gases include hydrogenated silanes such as monosilane and disilane, alkoxysilanes such as tetraethoxysilane and trimethoxysilane, straight chain siloxanes such as hexamethyldisiloxane, cyclic siloxanes such as 1,3,5,7-tetramethylcyclotetrasiloxane, silazanes such as hexamethyldisilazane, silanols such as trimethylsilanol, oxygen, nitrogen, ammonia, inert gases such as argon and helium, carbon monoxide, carbon dioxide, nitrogen dioxide, ozone, nitrous oxide, and amines such as monomethylamine. These gases may be incorporated at an amount of 10 to 99% by weight in relation to the silane compound.

The Si-containing film produced by the method as described above can be used as an insulator film having a reduced dielectric constant. As described above, the Si-containing film of the present invention is a material which is highly hydrophobic as bulk despite its porous nature, and has a high chemical stability, and in particular, a high resistance to alkaline washing solution due to the suppressed reactivity for nucleophilic reaction because of the low polarity of the silicon atom in the film. Accordingly, use of the Si-containing film of the present invention for the insulator film in the production of a semiconductor device enables production of the semiconductor device with improved reliability for the process induced damage in the subsequent production steps.

### EXAMPLES

Next, the present invention is described in further detail by referring to the Synthetic Examples, Examples, and Comparative Example, which by no means limit the scope of the present invention.

### Synthetic Example 1

### Synthesis of 1,2-bis(dimethoxymethyl silyl)ethane

A solution of chloroplatinic acid in butanol was added to 198 g of vinylmethyldimethoxysilane, and 159 g of dimethoxymethylsilane was gradually added dropwise to this solution. Due to the exothermic nature of the reaction, the addition rate was carefully adjusted so that the temperature of the reaction system would not exceed 80°C. After the completion of the dropwise addition, the mixture was distilled under reduced pressure to obtain 1,2-bis(dimethoxymethylsilyl)ethane. The boiling point was 126° C at 8.7×10³ Pa.

### Synthetic Example 2

### Synthesis of 1,2-bis(methoxymethylpropylsilyl)ethane

Propyl Grignard was prepared in THF (tetrahydrofuran) from 47.1 g of propyl chloride and 14.6 g of metal magnesium. To this solution was added a solution of 71.5 g of 1,2-(bismethyldimethoxysilyl)ethane in THF that had been prepared in a different flask. After 3 hours of heating and aging, the salt generated was removed by filtration, and after concentration, 1,2-bis(methoxymethylpropylsilyl)ethane was obtained by distillation under reduced pressure, which had a boiling point of 105°C at 0.13×10³ Pa.

### Synthetic Example 3

### Synthesis of 1,6-bis(dimethoxymethylsilyl)hexane

A solution of chloroplatinic acid in butanol was added to 41.1 g of 1,5-hexadiene, and 106.2 g of dimethoxymethylsilane was gradually added dropwise to this solution. Due to the exothermic nature of the reaction, the addition rate was carefully adjusted so that the temperature of the reaction system would not exceed 80°C. After the completion of the dropwise addition, the mixture was distilled under reduced pressure to obtain 1,6-bis(dimethoxymethylsilyl)hexane, which had a boiling point of 120°C at 0.13×10³ Pa.

### Example 1

### Formation of a 1,2-bis(methoxymethylpropylsilyl)ethane film by plasma CVD

A film of the 1,2-bis(methoxymethylpropylsilyl)ethane synthesized in Synthetic Example 2 was deposited on a silicon substrate by using the parallel plate, capacitively coupled PECVD reactor shown in FIG. 1.

In FIG. 1, the reactor (chamber) 1 has a source gas inlet tube 2, an inert gas inlet tube 3, an upper electrode 5, a lower electrode 6, and a discharge tube 7, and 4 is the sample.

The film was formed by supplying argon gas as the inert gas at 10 ml/min, and supplying vaporized 1,2-bis(methoxymethylpropylsllyl)ethane to maintain the interior pressure of the chamber at 5 Pa. The substrate temperature was 150°C, and RF power was 30 W with the frequency of 13.56 MHz. As a consequence, the film deposition rate was 5 nm/min.

### Examples 2 and 3

A film of 1,2-bis(methoxymethylpropylsilyl)ethane was deposited by repeating the procedure of Example 1 except that the interior pressure of the chamber was maintained at 20 Pa (Example 2) and 50 Pa (Example 3), respectively. As a consequence, the film deposition rate was 12 nm/min in Example 2, and 20 nm/min at Example 3.

### Example 4 and Comparative Example 1

A film was formed by repeating the procedure of Example 2 except that the material used in the Example 2 in forming the film was changed to 1,6-bis(dimethoxymethylsilyl)hexane prepared in Synthetic Example 3 (Example 2) and 1,2-bis(dimethoxymethylsilyl)ethane prepared in Synthetic Example 1 (Comparative Example 1), respectively. As a consequence, the film deposition rate was 13 nm/min in Example 4 and 15 nm/min in Comparative Example 1.

The resulting films were evaluated for their physical properties. More specifically, the relative dielectric constant was measured with 495-CV system (manufactured by SSM Japan K.K.) by using CV method using an automatic mercury probe, and the modulus (Young's modulus) was measured by using NanoIndenter (manufactured by the Nano Instruments Company).

The films were also irradiated with UV for 300 seconds by using a UV irradiator (Rapid Cure UV Source manufactured by Axcelis Technology), and the films were measured for their mechanical strength after the irradiation.

The results of the measurements are shown in Table 1.

**Table 1**

| | Sample | Interior pressure of the chamber (Pa) | Film deposition rate (nm/min) | Relative dielectric constant | Young's modulus of the as deposited film (GPa) | Young's modulus after UV irradiation (GPa) |
|---|---|---|---|---|---|---|
| Example 1 | Synthetic Example 2 | 5 | 5 | 2.7 | 5.3 | 9.7 |
| Example 2 | Synthetic Example 2 | 20 | 12 | 2.6 | 4.7 | 8.3 |
| Example 3 | Synthetic Example 2 | 50 | 20 | 2.5 | 4.2 | 7.7 |
| Example 4 | Example 3 | 20 | 13 | 2.6 | 4.5 | 8.2 |
| Comparative Example 1 | Synthetic Example 1 | 20 | 15 | 2.8 | 8.3 | 9.2 |

As demonstrated in the results shown in Table 1, the film forming method by CVD of the present invention was confirmed to be capable of depositing the a Si-containing film having a low dielectric constant at practically acceptable rate, and also, to be capable of forming a film having a relatively large alkyl group introduced therein which has a sufficiently high mechanical strength by the combined use of the irradiation of a high energy beam such as UV irradiation even though the as deposited film had a relatively low mechanical strength. It should be clear that the UV irradiation can be replaced with the irradiation of other high energy beam such as electron beam.

### Examples 5 to 8 and Comparative Example 2

### Evaluation of resistance to washing with a washing solution

The substrates having a film formed thereon produced in Examples 1 to 4 and Comparative Example 1 were immersed in a washing solution of a semiconductor containing hydroxylamine (EKC-518 manufactured by DuPont) at room temperature for 10 minutes to evaluate resistance to the washing solution.

The immersed substrate was then rinsed with pure water, dried, and evaluated for the relative dielectric constant to calculate difference in the change of the relative dielectric constant.

In the case of the films of Examples 1 to 4 (namely, the films of Examples 5 to 8), the relative dielectric constant was 2.7, 2.6, 2.6, and 2.6, respectively, and the increase was 0.0, 0.0, 0.1, and 0.0, respectively. On the other hand, the relative dielectric constant of the film of Comparative Example 1 (namely, the film of Comparative Example 2) was 3.2, and this corresponds to the increase of 0.4.

As demonstrated in the results as described above, the problem of increase in the relative dielectric constant in the subsequent production steps was sufficiently suppressed even with the use of the washing solution as described above since the Si-containing film formed by the plasma CVD method of the present invention has fewer number of oxygen atoms bonding to the silicon atoms which are involved in the constitution of three-dimensional structure, and the film as a bulk has a higher hydrophobicity.

## Claims

1. A method for depositing a Si-containing film by plasma CVD using a silane compound as film source, wherein the silane compound has hydrogen atom or an alkoxy group as a reactive group, and has at least 2 silicon atoms in the molecule; the at least 2 silicon atoms are bonded by an intervening straight chain, branched, or cyclic saturated hydrocarbon group, the straight chain saturated hydrocarbon group optionally including a cyclic structure; ratio of the number of carbon atoms other than those included in the alkoxy group [C] to the number of silicon atoms [Si] ([C]/[Si]) is at least 3; and all silicon atoms are directly bonded to at least 2 carbon atoms.

2. A method for depositing a Si-containing film according to claim 1 wherein the number of carbon atoms in one molecule of the silane compound is up to 20.

3. A method for depositing a Si-containing film according to claim 2 wherein the silane compound is the one represented by the following general formula (1): 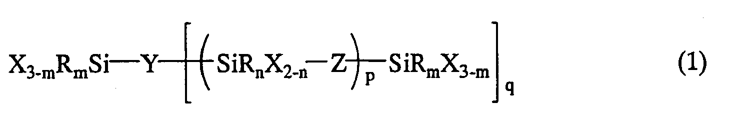 wherein
R is independently an alkyl group containing 1 to 6 carbon atoms,
X is independently hydrogen atom or an alkoxy group containing 1 to 4 carbon atoms,
Y is a straight chain, branched, or cyclic (q+1)-valent saturated hydrocarbon group containing 2 to 10 carbon atoms, the straight chain saturated hydrocarbon group optionally including a cyclic structure,
Z is a straight chain, branched, or cyclic divalent saturated hydrocarbon group containing 2 to 10 carbon atoms, the straight chain saturated hydrocarbon group optionally including a cyclic structure,
m is independently 1 or 2,
n is independently 1 or 2,
p is an integer of 0 to 2, and
q is an integer of 1 to 3,
with the proviso that ratio of the number of carbon atoms in the entire molecule doe not exceed 20, and the entire number of carbon atoms in the R, Y, and Z to the entire number of silicon atoms is at least 3.

4. A method for depositing a Si-containing film according to claim 3 wherein the silane compound is the one represented by the following general formula (2):
X₃₋ₘRₘSi-(CH₂)ₖ-SiRₘX₃₋ₘ (2)
wherein R, X, and m are as defined for the general formula (1); k is an integer of 2 to 6; and ratio of the number of carbon atoms in the methylene chain between the R and silicon to the entire number of silicon atoms is at least 3, and the entire number of carbon atoms is up to 20.

5. An insulator film produced by the method for depositing a Si-containing film of any one of claims 1 to 4.

6. A semiconductor device having the insulator film of claim 5.
